# EUROPÄISCHE PATENTSCHRIFT

(11) **EP 0 530 191 B1**
(45) Veröffentlichungstag und Bekanntmachung des Hinweises auf die Patenterteilung: **29.06.1994**
(21) Anmeldenummer: 91901577.6
(22) Anmeldetag: 21.12.1990
(51) Int. Cl.: H05K 3/34, H05K 13/00

(54) **VORRICHTUNG UND VERFAHREN ZUM POSITIONSGENAUEN LÖTEN VON LÖTTEILEN AUF EINEN TRÄGER**
PROCESS AND DEVICE FOR POSITIONALLY PRECISE SOLDERING OF PARTS TO BE SOLDERED ON A SUPPORTING PLATE
PROCEDE ET DISPOSITIF DE SOUDAGE DE PIECES A SOUDER DANS DES POSITIONS PRECISES SUR UN SUPPORT

(30) Priorität: 23.05.1990 DE 4016696
(43) Veröffentlichungstag der Anmeldung: 10.03.1993
(73) Patentinhaber: Siemens Nixdorf Informationssysteme Aktiengesellschaft, 33102 Paderborn (DE)
(72) Erfinder: EIDLING, Karl, D-8195 Egling (DE); BECKER, Michael, D-8000 München 90 (DE); KOHLER, Gerd, D-8000 München 19 (DE); EDINGER, Egon, D-8033 Krailling (DE); FRÖHLICH, Georg, D-8012 Ottobrunn (DE)
(74) Vertreter: Fuchs, Franz-Josef, Dr.-Ing.
(86) Internationale Anmeldenummer: DE9001003
(87) Internationale Veröffentlichungsnummer: WO9118490

(56) Entgegenhaltungen:
- EP-A- 0 214 030
- WO-A-89/08927
- US-A- 4 788 403
- US-A- 4 832 250
- US-A- 4 868 979

## Beschreibung

Die Erfindung betrifft eine Vorrichtung und ein Verfahren zum Aufbringen von genau positionierten Lötteilen auf einen Träger, wobei die Lötteile für den Lötvorgang auf einem Hilfstäger lösbar und gegeneinander positioniert befestigt sind, mit dem Hilfsträger auf den Träger überführt werden und der Hilfsträger nach dem Lötvorgang entfernt wird.

Das positionsgenaue Aufbringen von Lötteilen auf einen Träger ist insbesondere bei der Herstellung von LED-Zeilen, wie sie in Zeichengeneratoren eingesetzt werden, von großer Bedeutung. Lichtemittierende Dioden (LEDs) werden dabei nicht zu Anzeigezwecken, sondern zu Druckzwecken eingesetzt. Zeichengeneratoren dieser Art gehören zur Kategorie der nichtmechanischen Drucker. Die Genauigkeit der Positionierung innerhalb der LED-Zeilen und relativ zu einem Träger muß in allen drei Raumrichtungen in der Größenordnung von ± 3 - 10 »m liegen. Die Herstellung einer elektrisch leitenden und mechanisch tragenden Verbindung zwischen den LEDs und einem Träger, beispielsweise einer Modulplatte, kann durch Klebung oder durch Löten geschehen. Zur Gewährleistung bestimmter Toleranzen bietet die Klebung wesentliche Vorteile. Die sichere Ableitung der im Betrieb entstehenden Verlustwärme setzt jedoch eine optimale thermische Ankopplung voraus, wie sie nur durch Löten herstellbar ist. Die durch das Löten erzeugten Verschiebungen der LEDs während des Lötprozesses senken jedoch die Ausbeute.

Aus der Patentanmeldung WO 89/08927 ist ein Verfahren zur Herstellung von LED-Zeilen, insbesondere für den Zeichengenerator eines nichtmechanischen Druckers, bekannt. Durch die charakteristischen Eigenschaften der Herstellungsverfahren von LED-Bauteilen werden bestimmte maximale Längen dieser Bauteile nicht überschritten. Somit ist es zur Erstellung einer längeren LED-Zeile notwendig, mehrere Bauteile mit gegenseitig genauer Positionierung hintereinander anzuordnen. Die Positionierung bezieht sich auf den Teilungsabstand, die Linientreue und die Ebenheit der gesamten Oberfläche der LED-Zeile. Dabei ist bekannt, daß beim Einsatz eines Lötverfahrens entsprechend enge Toleranzen durch den Einsatz eines Hilfsträgers zur zwischenzeitlichen Halterung der LEDs erzielbar sind. Die LEDs werden zunächst mit ihrer aktiven Seite nach unten unter Benutzung hochpräziser optischer Justiermittel zu einer Zeile auf den Hilfsträger geklebt. Der so vorbereitete Hilfsträger wird mit der LED-Zeile auf den eigentlichen an entsprechenden Stellen mit Lot beschichteten Metallträger positioniert. Dabei wird die gesamte Anordnung fixiert, wobei die lötfähige Rückseite der LEDs das feste Lot auf dem Metallträger berührt. Bei der anschließenden Erwärmung auf Löttemperatur schmilzt das Lot und die LEDs werden davon benetzt bzw. tauchen bis zu einer durch Anschläge vorgegebenen Position darin ein. Durch die Fixierung bei fester Lotschicht und den anschließenden Phasenübergang des Lotes von der festen in die flüssige Phase, ergeben sich jedoch regelmäßig Dejustierungen. Die Ursache liegt in der Berührung der Lötpartner beim Einjustieren. Darüberhinaus wird zur Fixierung der Einheit eine Kraft auf den Hilfsträger durch ein aufgelegtes Gewicht erzeugt, wodurch vor oder während des Lötvorganges die LEDs beschädigt werden können. Da die gesamte Einheit mit den gegeneinander positionierten und fixierten Teilen eine relativ große Gesamtmasse aufweist, wird die Handhabung beispielsweise beim Dampfphasenlöten umständlich und es kann jeweils nur eine Einheit in einer Lötanlage für einen Lötvorgang appliziert werden.

Der Erfindung liegt die Aufgabe zugrunde, eine Vorrichtung und ein Verfahren bereitzustellen, womit die Lötpartner mit der geforderten Positionsgenauigkeit und ohne Beschädigung zusammengefügt werden können.

Die Lösung dieser Aufgabe wird durch den kennzeichnenden Teil des Anspruches 1 wiedergegeben.

Der Erfindung liegt die Erkenntnis zugrunde, daß die Lötpartner ohne Beschädigung und mit geforderter Positionsgenauigkeit verlötet werden können, indem sie erst nach dem Aufschmelzen des Lotes selbstgängig zusammengefügt werden. Die Lötvorrichtung und die Justiervorrichtung, die selbstständige Einheiten darstellen, sind dazu mit oder über die Lötpartner zu einem System verbunden. Die Justiervorrichtung richtet die Lötpartner gegeneinander aus und die Lötvorrichtung fixiert sie in der gewünschten Position. Die Lötvorrichtung wird vor dem Einbringen in die Lötanlage von der Justiervorrichtung getrennt. Zum selbstgängigen Fügen der Lötpartner werden diese in der Lötvorrichtung teilweise auf Federgelenken eingespannt, daß sie aus einer ersten Position bei blockierten Federgelenken nach dem Aufschmelzen des Lotes in eine zweite abgesenkte bzw. angenäherte Position gegeneinander verfahrbar sind und somit zusammengefügt werden. Zur Blockierung der Federelemente werden sogenannte Abstandselemente verwendet, deren Wirkung zeitlich begrenzt steuerbar ist.

Eine besonders vorteilhafte Ausgestaltung der Erfindung sieht anstelle der Abstandselemente den Einsatz von Schmelzscheiben vor. Die Schmelzscheiben sind derart ausgelegt, daß sie kurzzeitig nach dem Aufschmelzen des Lotes abschmelzen und somit die Blockierung der Federgelenke freigeben.

Eine weitere Ausgestaltung der Erfindung betrifft den Einsatz von selbstrückstellenden Schmelzelementen als Abstandselemente. Diese Schmelzelemente sind mehrfach verwendbar und weisen prinzipiell zwei Abstandselemente auf, die wechselweise zum Einsatz kommen. Die auf eine bestimmte Schmelztemperatur ausgelegte Substanz der Schmelzscheiben befindet sich in diesem Fall innerhalb der Schmelzelemente. Ein darauf aufgesetzter hutförmig ausgebildeter Körper, der mit seinem oberen Teil beweglich aus dem Schmelzelement herausgeführt ist, bestimmt zusammen mit der festen Substanz einen gewünschten Abstand. Beim Aufschmelzen der Substanz wird unter Einwirkung einer äußeren Kraft der hutförmig ausgebildete Körper in die Substanz eingedrückt und somit die Beabstandung aufgehoben. Mittels einer internen Feder läßt sich dieses Eintauchen bei aufgeschmolzenem Zustand der Substanz rückgängig machen.

Die Befestigung der Lötteile auf dem Hilfsträger ist vorzugsweise eine Klebung. Die Klebung bietet optimale Voraussetzungen für ein positionsgenaues Aufbringen und gegenseitiges Ausrichten der Lötteile.

Zur einfacheren Handhabung bei gleichzeitig gewährleisteter positionsgenauer Ausrichtung der Lötteile wird der Hilfsträger in besonderer Weise mit einzeln ansteuerbaren nebeneinander angeordneten und zum Ansaugen der Lötteile ausgelegten Saugkammern ausgebildet. Durch einen derartigen Hilfsträger entfallen die nach dem Umlöten der Lötteile auf den Träger vorgesehenen naßchemischen Prozesse zum Ablösen und Reinigen, sowie mechanische Reinigungsprozesse.

Sind Träger und Hilfsträger beheizbar, so entfällt prinzipiell die Verwendung einer herkömmlichen Lötanlage. Die Energie zum Aufschmelzen des Lotes, sowie die Aufheizung der Lötpartner auf annähernd gleiche Temperaturen erfolgt direkt am Träger bzw. am Hilfsträger. Mit der annähernd gleich hohen Aufheizung wird ein positionsgenaues Löten gewährleistet, wobei auch nach dem Abkühlen der Lötpartner reproduzierbare Positionierungen zwischen den Lötpartnern innerhalb der geforderten Toleranzbereiche erzielbar sind.

Im folgenden werden anhand von schematischen Figuren Ausführungsbeispiele beschrieben.
- Figur 1: zeigt eine Lötvorrichtung 3 mit einer Justiervorrichtung 4 mit Hilfsträger 5 und Träger 6 in der Frontansicht,
- Figur 2: zeigt eine Vorrichtung entsprechend der Figur 1 in der Draufsicht,
- Figur 3: zeigt eine Seitenansicht der Vorrichtung, wobei Mikroskopschlitten 14 und Meßoptik 17 dargestellt sind,
- Figur 4: zeigt ein selbstrückstellendes Schmelzelement 26,
- Figur 5: zeigt eine schematisierte Frontansicht der Vorrichtung mit einem aus Saugkammern 30 bestehenden Hilfsträger 5.

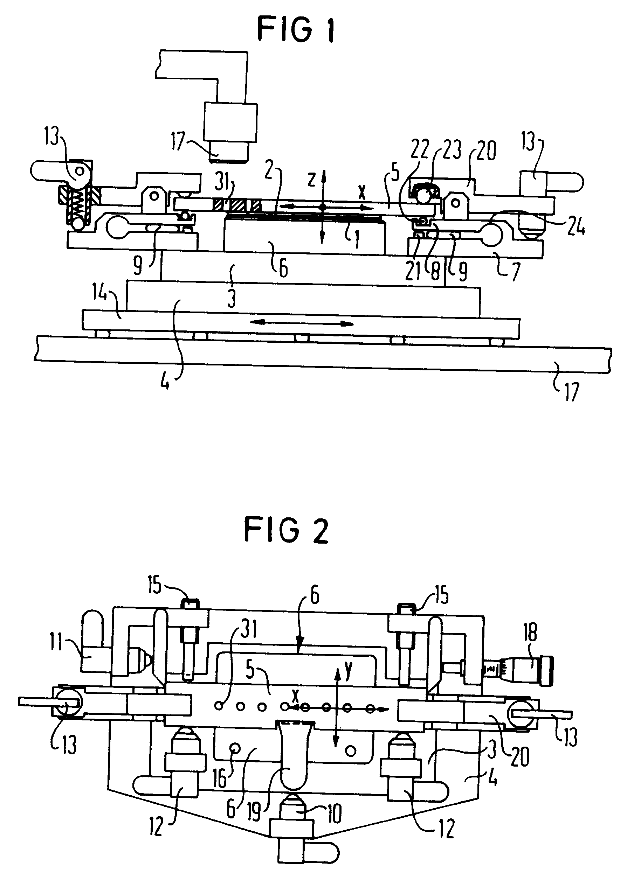

Die Figur 1 zeigt eine auf einem Grundkörper mit Meßtisch angeordnete Meßoptik 17, mittels derer die gegenseitige Ausrichtung zwischen dem Hilfsträger 5 und dem Träger 6 innerhalb der Lötvorrichtung durch die Justiervorrichtung durchführbar ist. Dabei wird jeweils auf das kartesische X, Y, Z-Koordinatensystem Bezug genommen, wobei die Z-Richtung die Höhe wiedergibt. Die am Hilfsträger 5 zwischenzeitlich befestigten und ausgerichteten Lotteile 1 sind in einem vorgegebenen Abstand in einer ersten Position in annähernd paralleler Ausrichtung bezogen auf die Oberfläche des Trägers 6 positioniert. Auf der entsprechenden Oberfläche des Trägers 6 befindet sich eine Schicht aus Lot 2.

Der Mikroskopschlitten 14 nimmt die Justiervorrichtung 4 auf, die ihrerseits die Lötvorrichtung 3 trägt. Innerhalb der Lötvorrichtung 3 werden der Träger 6 und der Hilfsträger 5 über Absenkblöcke 7 gegeneinander beabstandet gelagert. Die Beabstandung sieht zwei Positionen vor, wobei die erste durch Abstandselemente 9, die in die zu den Absenkblöcken 7 gehörenden Federgelenke 24 eingebracht sind, festgelegt ist und die zweite durch Z-Anschläge 21 hergestellt wird. Zur Auflage des Hilfsträgers 5 auf die Federgelenke 24 sind Auflagezungen 8 ausgebildet, wobei zwischengelagerte Rollen 22 vorhanden sind. Die Einspannung des Hilfsträgers 5 in Bezug auf die Lötvorrichtung 3 geschieht über federunterstützte Spannelemente 13, wobei in diesem Fall Kugeln 23 zwischengelagert sind. Die Kraftübertragung von den Spannelementen 13 zum Hilfsträger 5 geschieht über Spannhebel 20. Die Durchgangsbohrungen 31 des Hilfsträgers 5 sind gegeneinander derart beabstandet, daß sie jeweils an einer Stoßstelle zwischen zwei Lötteilen 1 plaziert sind und somit die gegenseitige Ausrichtung der Lotteile 1, wie auch die Ausrichtung zwischen Hilfsträger 5 und Träger 6 ermöglichen. Die Feinpositionierung geschieht mittels der Meßoptik 17. Elemente zur Einstellung der relativen Position des Hilfsträgers 5 zum Träger 6 sind in der Figur 1 nicht widergegeben. Die Figur 1 bezieht sich im wesentlichen auf die Darstellung der Lötvorrichtung 3, die nach dem Justiervorgang einzeln handhabbar ist und somit ohne die Justiervorrichtung 4 beispielsweise in eine Lötkammer eingebracht werden kann.

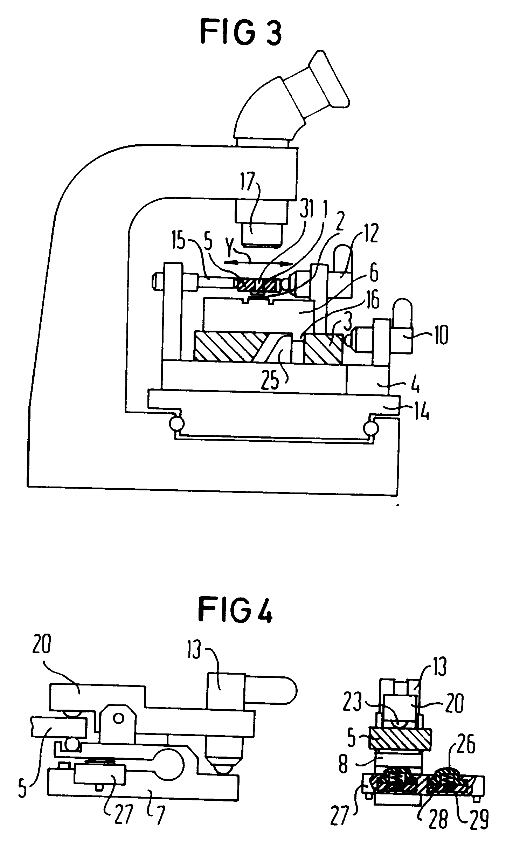

Die Figur 2 zeigt eine Draufsicht der Anordnung entsprechend Figur 1, wobei die Meßoptik 17 nicht dargestellt ist. Der Träger 6 ist über Stifte 16 relativ zur Justiervorrichtung 4 ausgerichtet. Die Justiervorrichtung 4 beinhaltet die Spannelemente 10, 11, 12 , ein X-Justierelement 18 und Y-Anschläge 15. Die Position der Lötvorrichtung 3 relativ zur Justiervorrichtung 4 wird mittels Y-Anschläge 25 (Figur 3) und Stiften 16 festgelegt, wobei die Anschläge 25 zur Justiervorrichtung 4 gehören und die Stifte 16 zum Träger 6. Damit ist eine exakte Positionierung des Trägers 6 in Y-Richtung gegeben, wobei die Position des Trägers 6 relativ zur Justiervorrichtung 4 in X-Richtung grob eingestellt wird. Der Träger 6 wird durch das Spannelement 10 an die Lötvorrichtung 3 und an die Justiervorrichtung 4 gespannt, wobei die ebene Ausrichtung aller drei Teile relativ zueinander gewährleistet ist. Die X-Richtung ist hierbei zweckmäßiger Weise die Fahrtrichtung des Mikroskopschlitten 14, wobei der Mikroskopschlitten sich insgesamt parallel zur X, Y-Ebene bewegt. Nach dem Einlegen des mit Lotteilen 1 bestückten Hilfsträgers 5 in die Lötvorrichtung 3 wird dieser in Y-Richtung durch Andrücken an die Y-Anschläge 15 und durch Einspannen zwischen das Spannelement 11 und das Justierelement 18 in X-Richtung positioniert und mittels der Meßoptik 17 in X-Richtung relativ zum Träger 6 feinjustiert. Daran anschließend wird der Hilfsträger 5 über den Mittenführungsbacken 19 fixiert. Durch Schließen der Spannelemente 13 wird der Hilfsträger 5 in Z-Richtung über die Auflagezungen 8 gegen die Abstandselemente 9 vorgespannt und gleichzeitig zwischen den Auflagezungen 8 und den Spannhebeln 20 eingespannt. Somit sind Lotteile 1 über Hilfsträger 5 relativ zum Träger 6 justiert und fixiert. Nach dem Öffnen der Spannelemente 10, 11, 12 kann die Lötvorrichtung 3 aus der Justiervorrichtung 4 entnommen werden und in eine Lötanlage gegeben werden.

Die Figur 3 zeigt eine Seitenansicht einer erfindungsgemäßen Anordnung, wobei von unten her auf einem Rahmen eines Mikroskopes mit einer Meßoptik 17 der Mikroskopschlitten 14, die Justiervorrichtung 4, die Lötvorrichtung 3, der Träger 6 und der Hilfsträger 5 dargestellt sind. Zur Justiervorrichtung 4 gehören die Spannelemente 10, 12 , die Y-Anschläge 15 und die Anschläge 25. Die Spannelemente 13 der Lötvorrichtung 3 sind hier nicht dargestellt.

Die Figur 4 zeigt einen Absenkblock 7 mit einem entsprechenden Spannelement 13, andeutungsweise einen Hilfsträger 5 und einen Schieber 27. In der geschnittenen Darstellung sind von oben her zunächst das Spannelement 13 mit einer zugehörigen Kugel 23 und der Hilfsträger 5, sowie die zum Absenkblock 7 gehörige Auflagezunge 8 dargestellt. Der Schieber 27 beinhaltet zwei Abstandselemente 9, die als Schmelzelemente 26 ausgebildet sind. Die Abstandselemente 9, die in einer Variante als aus Lot bestehende Schmelzscheiben dargestellt wurden, können durch derartige Schmelzelemente 26 ersetzt werden. Der Vorteil liegt in der Wiederverwendbarkeit. Hierzu sind die Schmelzelemente 26, die in Führungen des Schiebers 27 bewegbar sind, federunterstützt gelagert und ein unter dem Schmelzelement 26 befindlicher Hohlraum im Schieber 27 enthält eine Elementfüllung 28. Die Elementfüllung 28 besteht in einfacher Weise aus Lot, das eine definierte Schmelztemperatur besitzt. Im schmelzflüssigen Zustand wird das Schmelzelement 26 durch die Feder 29 nach oben gedrückt, wobei die Kraft der Feder 29 jedoch geringer ist, als die über das Spannelement 13 aufgebrachte Kraft. Somit wird eine Rückstellung des Schmelzelementes 26 im entlasteten Zustand durch die Feder 29 gewährleistet, wenn die Elementfüllung aufgeschmolzen ist. Ist die Elementfüllung 28 erstarrt und ragt das Schmelzelement 26 aus dem Schieber 27 heraus, so wirkt die gesamte Anordnung als Abstandselement 9.

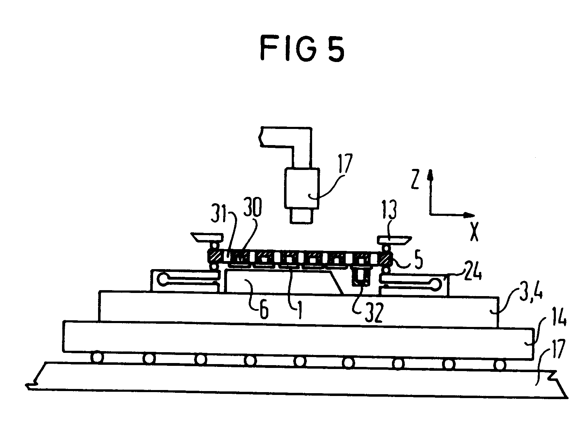

In der Figur 5 ist eine erfindungsgemäße Anordnung dargestellt, wobei die Lötvorrichtung 3 und die Justiervorrichtung 4, sowie der Mikroskopschlitten 14 und die Meßoptik 17 vereinfacht angedeutet sind. Zur einfacheren Handhabung ist der Hilfsträger 5 mit Saugkammern 30 ausgestattet, die jeweils ein Lötteil 1 mittels Vakuum ansaugen und festhalten. Für die Meßoptik 17 und die Durchgangsbohrungen 31 kann wie beschrieben die relative Ausrichtung zwischen Hilfsträger 5 und Träger 6 durchgeführt werden. Zusätzlich ist in der Figur 5 ein Übergabegreifer 32 angedeutet, der ebenfalls Lotteile 1 mittels Vakuum ansaugen und halten kann. Mit dem Übergabegreifer 32 werden die Lotteile 1 vor dem Einlegen des Hilfsträgers 5 in die gesamte Vorrichtung unter dem Hilfsträger 5 positioniert und an jede einzelne Saugkammer 30 übergeben. Diese Ausgestaltung der Erfindung erübrigt eine Klebung zwischen Lotteilen 1 und Hilfsträger 5, wodurch Beschädigungen durch mechanische und naßchemische Reinigungsverfahren an den Lotteilen beim Entfernen des Hilfsträgers vermieden werden.

Bei ansonsten gleichbleibender Konstruktion von Lötvorrichtung 3 und Justiervorrichtung 4 besteht die Möglichkeit, den Träger 6 und den Hilfsträger 5 direkt oder indirekt zu beheizen und somit die nötige Energie zur Durchführung des Lötvorgangs bereitzustellen. Zweckmäßigerweise würde der Übergabegreifer 32 ebenfalls beheizt werden. Mit dieser Ausgestaltung verringert sich die Zahl der Verfahrensschritte bezüglich der Justage und der Montage; außerdem kann der gesamte Vorgang einschließlich des Lötens in einer Aufspannung ablaufen. Eine bisher eingesetzte Lötanlage, beispielsweise eine Dampfphasenlötanlage, entfällt. Nachjustierungen sind während des Prozesses möglich.

Eine erfindungsgemäße Vorrichtung und das zugehörige Verfahren werden insbesondere zur Herstellung von Zeichengeneratoren für nichtmechanische Drucker verwendet. Hierbei werden Leuchtdiodenchips (LED-Zeilen) auf Modulplatten aufgelötet. Aus der durch die Konstruktion der Vorrichtung resultierenden Verfahrensweise, daß die Lötpartner erst zusammengefügt werden, wenn das auf der Modulplatte aufgebrachte Lot bereits geschmolzen ist, resultieren erhebliche Vorteile bezüglich der Positionsgenauigkeit der einzelnen Leuchtdiodenchips, die eine LED-Zeile bilden. Der Einsatz von elektrischen oder pneumatischen, sensorgesteuerten Stellgliedern wird durch die Verwendung von Abstandselementen 9, die als Schmelzscheiben oder als Schmelzelemente 26 ausgebildet werden können, überflüssig. Die durch die Z-Anschläge 21 vorbestimmte zweite Position des Hilfsträgers 5 wird nach dem Aufschmelzen der Schmelzscheiben unter der Federkraft der Spannelemente 13 zuverlässig erreicht.

Weitere Vorteile einer erfindungsgemäßen Vorrichtung bestehen in dem gleichbleibenden definierten Abstand der Modulplatte zur Meßoptik 17, wodurch der Bereich der Schärfentiefe nicht verlassen wird. Durch die Vermeidung von mechanischen Belastungen der LEDs und dem Kontakt zwischen LED und festem Lot 2 werden Brüche oder andere Beschädigungen der elektronischen Bauteile vermieden. Durch den Einsatz eines Mittenführungsbakkens 19 wird eine zentrische Einspannung bereitgestellt, die zu einer Halbierung der durch thermische Ausdehnungsfaktoren bedingten Verschiebungen, verursacht durch Temperaturdifferenzen während des Erstarren des Lotes, führt. Bei Verwendung von Lötanlagen ist eine bessere Kapazitätsauslastung gegeben, da lediglich die Lötvorrichtung 3, aber nicht die erfindungsgemäß abtrennbare Justiervorrichtung 4 in die Lötanlage eingebracht werden muß. Die Vorrichtung ist durch den Einsatz von Rollen 22, Kugeln 23 und federunterstützten Elementen spielfrei bei konstanter Spannkraft ausgeführt. Die Absenkbewegung des Hilfsträgers 5 bzw. das Zusammenfügen der Lötpartner ist durch Vorgabe des Schmelzpunktes bzw. der Masse der Schmelzscheiben oder der Elementfüllung 28 exakt einstellbar. Außerdem ist die gesamte Justiervorrichtung 4 keiner erhöhten Temperatur und keinem Lötmedium ausgesetzt, das auf Dauer ihre Funktion beeinträchtigen könnte. Beim Einsatz eines beheizten Hilfsträgers 5 und einer beheizten Modulplatte wird zusätzlich die Lötvorrichtung 3 geschont.

Ein typischer Fall eines Lötvorganges zur Herstellung einer mit LED-Zeilen bestückten Modulplatte sieht eine Löttemperatur von 215 Grad Celsius vor.

## Patentansprüche

1. Vorrichtung zum positionsgenauen Löten von Lötteilen (1) auf einen Träger (6), wobei die Lötteile (1) für den Lötvorgang lösbar und gegeneinander positioniert auf einem Hilfsträger (5) befestigt sind, insbesondere zur Herstellung von LED-Zeilen, **gekennzeichnet durch**,
a) eine Lötvorrichtung (3) zur Aufnahme von Träger (6) und Hilfsträger (5) bei gegenseitiger Lagefixierung
- mit mindestens zwei durch Abstandselemente (9) zeitweise in einer ersten Position blockierbaren Federgelenken (24) zur gegenüber dem Träger (6) beabstandeten Lagerung des auf den Federgelenken (24) aufliegenden Hilfsträgers (5),
- mit senkrecht zum Hilfsträger (5) wirkenden Z - Anschlägen (21) zur jeweiligen Blockierung der Federngelenke (24) in einer zweiten Position bei nicht vorhandenen Abstandselementen (9),
- mit federunterstützten Spannelementen (13) zum jeweiligen Einspannen des Hilfsträgers (5) bezüglich eines Federgelenkes (24),
- wobei der Hilfsträger (5) mittels einer von den Spannelementen (13) aufgebrachten Kraft aus der ersten in die zweite Position mit zusammengefügten Lotpartnern überführbar ist,
b) eine Justiervorrichtung (4) zur gegenseitigen lateralen Ausrichtung zwischen Träger (6) und Hilfsträger (5)
- mit Spannelementen (10, 11, 12), mit parallel zur Ebene des Hilfsträgerswirkenden Y-Anschlägen (15, 25) und X-Justierelementen (18),
- wobei die Lötvorrichtung (3) und der Träger (6) über Stifte (16) des Trägers (6) und die Y-Anschläge (25), sowie der Hilfsträger (5) über die Y-Anschläge (15) auf die Justiervorrichtung (4) ausrichtbar sind.

2. Vorrichtung nach Anspruch 1, **dadurch gekennzeichnet**, daß die Abstandselemente (9) Schmelzscheiben sind.

3. Vorrichtung nach Anspruch 2, **dadurch gekennzeichnet**, daß die Schmelzscheiben selbstrückstellende Schmelzelemente (26) sind.

4. Vorrichtung nach einem der vorgehenden Ansprüche, **dadurch gekennzeichnet**, daß die Befestigung der Lötteile (1) auf dem Hilfsträger (5) eine Klebung ist.

5. Vorrichtung nach einem der Ansprüche 1 - 3, **dadurch** **gekennzeichnet**, daß der Hilfsträger (5) einzeln ansteuerbare Saugkammern (30) zum Ansaugen der Lötteile (1) aufweist.

6. Vorrichtung nach Anspruch 5, **dadurch gekennzeichnet**, daß der Träger (6) und der Hilfsträger (5) elektrisch beheizbar sind.

7. Verfahren zum positionsgenauen Löten von Lötteilen (1) auf einen Träger (6) mittels einer Vorrichtung nach einem der Ansprüche 2 - 6, **dadurch gekennzeichnet**, daß die Schmelzscheiben an den Federgelenken (24) nach einem auf dem Träger (6) befindlichen Lot aufschmelzen und somit bei einer Absenkbewegung des Hilfsträgers (5) aus der ersten in die zweite Position die Lotteile (1) in bereits geschmolzenen Lot auf dem Träger (6) eintauchen.

## Claims

1. Device for accurately-positioned soldering of soldered components (1) onto a support (6), the soldered components (1) being fastened in a detachable manner and positioned with respect to one another on an auxiliary support (5), for the soldering procedure, preferably for the production of LED rows, characterized by
a) a soldering device (3) for holding supports (6) and auxiliary supports (5) in the case of mutual position fixing
- having at least two spring joints (24) being blockable by spacing elements (9) at times in a first position for mounting at a distance from the support (6) of the auxiliary support (5) resting on the spring joints (24),
- having Z-stops (21) acting perpendicularly to the auxiliary support (5) for the respective blocking of the spring joints (24) in a second position when no spacing elements (9) are present,
- having spring-supported clamping elements (13) for the respective clamping of the auxiliary support (5) relative to a spring joint (24),
- the auxiliary support (5) together with joint soldered partners being transferable from the first into the second position by means of a force applied by the clamping elements (13),
b) an adjusting device (4) for the mutual lateral alignment of support (6) and auxiliary support (5)
- having clamping elements (10, 11, 12) which have Y-stops (15, 25) acting parallel to the plane of the auxiliary support, and have X-adjusting devices (18),
- the soldering device (3) and the support (6) being capable of alignment to the adjusting device (4) by means of pins (16) of the support (6) and by means of the Y-stops (25), and to the auxiliary support (5) by means of the Y-stops (15).

2. Device according to Claim 1, characterized in that the spacing elements (9) are melting discs.

3. Device according to Claim 2, characterized in that the melting discs are self-restoring melting elements (26).

4. Device according to one of the preceding claims, characterized in that the fastening of the soldered components (1) on the auxiliary support (5) is a glued connection.

5. Device according to one of Claims 1-3, characterized in that the auxiliary support (5) exhibits individually controllable suction chambers (30) for sucking the soldered components (1) on.

6. Device according to Claim 5, characterized in that the support (6) and the auxiliary support (5) are electrically heatable.

7. Method for accurately-positioned soldering of soldered components (1) on a support (6) by means of a device according to one of Claims 2-6, characterized in that the melting discs on the spring joints (24) melt after solder which is located on the support (6) and thus, in the case of a lowering movement of the auxiliary support (5) from the first into the second position, the soldered components dip into the already molten solder on the support (6).

## Revendications

1. Dispositif pour fixer par brasage, dans une position précise, des pièces à braser (1) sur un support (6), les pièces à braser (1) étant fixées, pour l'opération de brasage, de façon amovible et en étant positionnées les unes par rapport aux autres sur un support auxiliaire (5), notamment pour la fabrication de lignes de diodes LED, caractérisé par
a) un dispositif de brasage (3) destiné à reçevoir le support (6) et le support auxiliaire (5) pour une immobilisation relative en position, et comportant
- au moins des articulations élastiques (24), qui peuvent être bloquées temporairement dans une première position par des entretoises (9) et qui sont destinés à supporter, à distance du support (6), le support auxiliaire (5) appliqué sur les articulations élastiques (24),
- des butées suivant Z (21), agissant perpendiculairement au support auxiliaire (5) et destinées à bloquer les articulations élastiques (24) dans une seconde position en l'absence d'entretoises (9),
- des éléments de blocage (13) assistés par des ressorts et destinés à bloquer le support auxiliaire (5) par rapport à une articulation élastique (24),
- le support auxiliaire (5) pouvant être amené, sous l'effet d'une force appliquée par les éléments de blocage (13), de la première position à la seconde position avec des partenaires de brasage, qui sont assemblés,
b) un dispositif d'ajustement (4) pour réaliser un alignement latéral mutuel entre le support (6) et le support auxiliaire (5),
- des éléments de blocage (10, 11, 12), comportant des butées suivant Y (15, 25) agissant parallèlement au plan du support auxiliaire, et des éléments d'ajustement suivant X (18),
- le dispositif de brasage (3) et le support (6) pouvant être alignés au moyen de tiges (16) du support (6), tandis que les butées suivant Y (25) et le support auxiliaire (5) peuvent être alignés par l'intermédiaire des butées suivant Y (15) sur le dispositif d'ajustement (4).

2. Dispositif suivant la revendication 1, caractérisé par le fait que les entretoises (9) sont des disques fusibles.

3. Dispositif suivant la revendication 2, caractérisé par le fait que les disques fusibles sont des éléments fusibles (26) se remettant en place d'eux-mêmes.

4. Dispositif suivant l'une des revendications précédentes, caractérisé par le fait que la fixation des pièces à braser (1) sur le support auxiliaire (5) est un collage.

5. Dispositif suivant l'une des revendications 1-3, caractérisé par le fait que le support auxiliaire (5) comporte des ventouses aspirantes (30) pouvant être commandées individuellement et destinées à maintenir les pièces à braser (1) par aspiration.

6. Dispositif suivant la revendication 5, caractérisé par le fait que le support (6) et le support auxiliaire (5) peuvent être chauffés électriquement.

7. Procédé de fixation par brasage, d'une manière précise en position, de pièces à braser (1) sur un support (6) à l'aide d'un dispositif selon l'une des revendications 2 à 6, caractérisé par le fait que les disques fusibles situés sur les articulations élastiques (24) fondent sur ces dernières (24) après une brasure se trouvant sur le support (6) et par conséquent, lors d'un abaissement du support auxiliaire (5) de la première position à la seconde position, les pièces à braser (1) pénètrent dans la brasure déjà fondue sur le support (6).
